# EUROPEAN PATENT APPLICATION

(11) **EP 4 007 056 A1**
(43) Date of publication of application: **01.06.2022**
(21) Application number: 21207975.0
(22) Date of filing: 12.11.2021
(51) Int. Cl.: H01M 50/284, H01M 50/519

(54) **BATTERY MODULE AND BATTERY MODULE WITH WIRED CIRCUIT BOARD**

(30) Priority: 27.11.2020 JP 2020196569
(71) Applicant: Nitto Denko Corporation, Ibaraki-shi Osaka 567-8680 (JP)
(72) Inventor: Inoue, Masami, Ibaraki-shi, Osaka, 567-8680 (JP); Suzuki, Masafumi, Ibaraki-shi, Osaka, 567-8680 (JP)
(74) Representative: Hoffmann Eitle

(57) **Abstract**

A battery module 1 includes: a battery 2 having a flat shape and including an electrode 5 disposed on a one-side surface 6 in the thickness direction; and a metal plate 3 disposed at one side in the thickness direction relative to the electrode 5. The metal plate 3 has electrode bond portions 7 bonded to the electrode 5. The metal plate 3 includes: a board bondable portion 8 bondable to a wired circuit board 18 via a molten metal 19; and an opening 10 penetrating the metal plate 3 in the thickness direction. The opening10 is disposed between the electrode bond portions 7 and board bondable portion 8.

## Description

### TECHNICAL FIELD

The present invention relates to a battery module and a battery module with a wired circuit board.

A battery module with a board has been known. The battery module with a board includes a button-shaped battery having an electrode on its upper surface, a metallic electrode tab, and a wired circuit board (for example, see Patent Document 1 cited below).

### BACKGROUND ART

In the battery module with a board described in Patent Document 1, the electrode tab and wired circuit board are disposed sequentially on the battery. Thus, the battery module with a board described in Patent Document 1 is compact in a surface direction.

In the battery module with a board described in Patent Document 1, the electrode tab is bonded to the electrode of the battery, and to the wired circuit board. In the electrode tab, the part bonded to the electrode of the battery is displaced from the part bonded to the wired circuit board in the surface direction.

### Citation List

### Patent Document

Patent Document 1: Japanese Unexamined Patent Publication No. 2019-40860

### SUMMARY OF THE INVENTION

### PROBLEM TO BE SOLVED BY THE INVENTION

When the electrode tab bonded to the electrode of the battery is further bonded to the wired circuit board via a solder, the solder is disposed between the electrode tab and wired circuit board and a heated chip is pressed to a part of the wired circuit board corresponding to the solder. In this manner, the solder is molten by the heating. The heat from the heated chip successfully travels through the part where the wired circuit board and electrode tab are bonded to the metallic electrode tab in the surface direction. The heat adversely travels to the electrode of the battery through the bonding part between the electrode tab and battery. This causes a disadvantage that the properties of the battery are deteriorated.

The present invention provides a battery module and a battery module with a wired circuit board, both of which are compact in the surface direction and can suppress the heat transfer to the electrode of the battery when the metal plate is bonded to the wired circuit board via a molten metal.

### MEANS FOR SOLVING THE PROBLEM

The present invention [1] includes a battery module comprising: a battery having a flat shape and including an electrode disposed on a one-side surface in a thickness direction of the battery; and a metal plate disposed at one side in the thickness direction relative the electrode, the metal plate having an electrode bond portion bonded to the electrode, wherein the metal plate includes: a board bondable portion bondable to a wired circuit board via a molten metal; and an opening disposed between the electrode bond portion and the board bondable portion, and penetrating the metal plate in the thickness direction.

In the battery module, the metal plate is disposed at the one side in the thickness direction of the electrode. Thus, the metal plate can compactly be disposed in the surface direction.

In addition, when the board bondable portion is bonded to the wired circuit board via the molten metal and the heat of the molten metal transfers to the board bondable portion, the opening can suppress the adverse heat transfer to the electrode bond portion. Thus, the deterioration of the properties of the battery can be suppressed.

The present invention [2] includes the battery module described in [1] above, further including a plating layer disposed on a one-side surface in the thickness direction of the board bondable portion.

In the battery module, the plating layer enables the molten metal to easily wet and spread over the plating layer when the board bondable portion is bonded to the wired circuit board via the molten metal.

The present invention [3] includes the battery module described in [1] or [2] above, wherein a ratio (L2/L1) of a length L2 of the opening to a length L1 of a line segment passing through the opening in the metal plate is 0.3 or more in a direction orthogonal to a direction in which the electrode bond portion and board bondable portion are lined.

In the battery module, the ratio (L2/L1) is 0.3 or more. Thus, when the wired circuit board is bonded to the board bondable portion, the heat transfer to the electrode bond portion can efficiently be suppressed.

The present invention [4] includes a battery module with a wired circuit board comprising: a wired circuit board; a molten metal; and the battery module described in any one of [1] to [3] above, wherein the wired circuit board is bonded to the board bondable portion via the molten metal.

The battery module with the wired circuit board includes the above-described battery module, and the opening suppresses adverse heat transfer to the electrode bond portion even when the board bondable portion is bonded to the wired circuit board via the molten metal and the heat of the molten metal transfers to the board bondable portion. Thus, in the battery module with the wired circuit board, the deterioration of the properties of the battery is suppressed.

### EFFECTS OF THE INVENTION

The battery module of the present invention is compact in the surface direction, and simultaneously can suppress the heat transfer to the electrode of the battery when the metal plate is bonded to the wired circuit board via the molten metal.

The battery module of the present invention is compact, and simultaneously suppresses the deterioration of the properties of the battery.

### BRIEF DESCRIPTION OF THE DRAWINGS

[FIG. 1] FIG. 1 is a plan view of an embodiment of the battery module of the present invention.
[FIG. 2] FIG. 2 is a cross-sectional view of the battery module illustrated in FIG. 1, taken along line X-X of FIG. 1.
[FIG. 3] FIG. 3 is a plan view of a variation of the battery module.

### DESCRIPTION OF THE EMBODIMENTS

### <Embodiment of Battery Module>

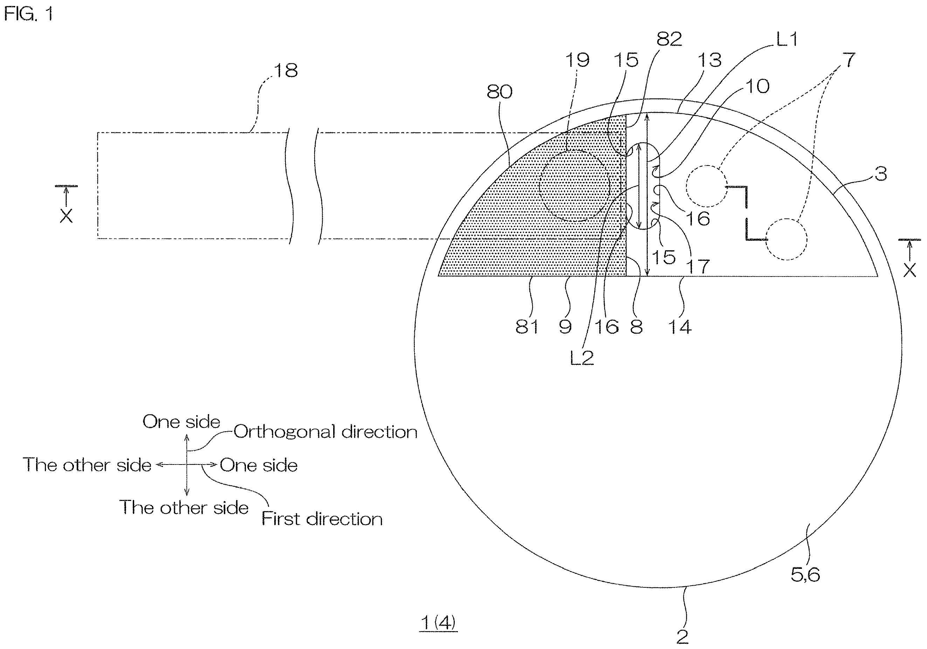

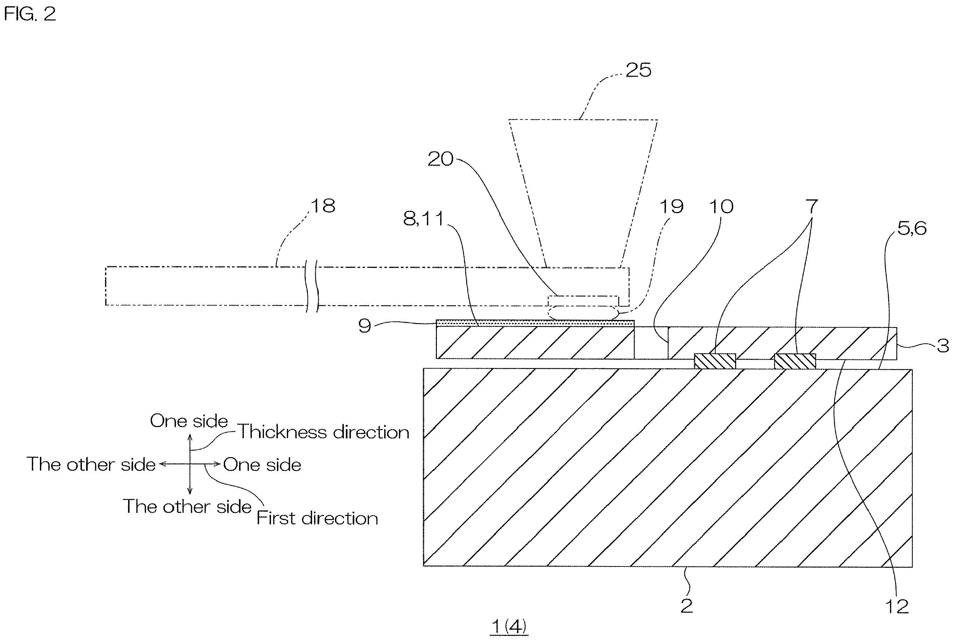

An embodiment of the battery module of the present invention is described with reference to FIG. 1 and FIG. 2. A battery module 1 includes a battery 2 and a metal plate 3. The battery module 1 has not included a wired circuit board 18 and a molten metal 19, which are described below, yet. The battery module 1 is not the battery module with a wired circuit board 4, which is also described below.

### <Battery 2>

The battery 2 has a flat shape. Specifically, the battery 2 has an approximately cylindrical shape with a diameter longer than its axial-direction length. The axial direction of the battery 2 is a thickness direction. The battery 2 is, for example, button-shaped. The battery 2 has a one-side surface 6 and the other-side surface in the thickness direction, and a peripheral side surface. The one-side surface 6 has an approximately circular shape in the plan view. The other-side surface is disposed at the other side in the thickness direction relative to the one-side surface 6 with a space therebetween. The peripheral side surface connects a peripheral edge of the one-side surface 6 and a peripheral edge of the other-side surface. The battery 2 has an electrode 5 on the one-side surface 6. The electrode 5 forms the one-side surface 6 of the battery 2.

### <Metal plate 3>

The metal plate 3 may be referred to as a connection tab. The metal plate 3 is disposed at one side in the thickness direction relative to the electrode 5. The whole of the metal plate 3 is encompassed in the battery 2 when being projected in the thickness direction. The metal plate 3 has an approximately arcuate shape in the plan view. The outer peripheral edge of the metal plate 3 has an arc portion 13 and a chord portion 14. The arc portion 13 is disposed along a part of the arc of the outer peripheral edge of the electrode 5. The inscribed angle of the arc portion 13 is not especially limited. The chord portion 14 connects both ends of the arc portion 13. The chord portion 14 has an approximately straight line shape in the plan view. The chord portion 14 is displaced outward from the center of the electrode 5. Examples of the material of the metal plate 3 include aluminum and a stainless steel. In terms of strength and stiffness, preferably, a stainless steel is used. The thickness of the metal plate 3 is not especially limited. The metal plate 3 has a thickness of, for example, 50 µm or more and 100 µm or more and, for example, 1000 µm or less, preferably, 500 µm or less. The metal plate 3 includes electrode bond portions 7, a board bondable portion 8, and an opening 10.

### <Electrode Bond Portions 7>

The electrode bond portions 7 are disposed at a one-side portion in a first direction of the metal plate 3. The first direction is a direction along the chord portion 14. The electrode bond portions 7 are separated from each other with a space therebetween. The electrode bond portions 7 are disposed on the other-side surface 12 of the metal plate 3. The electrode bond portions 7 are parts formed by, for example, laser welding the metal plate 3. The electrode bond portions 7 are bonded to the electrode 5. Thus, the material of the electrode bond portions 7 is the same as that of the metal plate 3. The shapes and dimensions of the electrode bond portions 7 are not especially limited. For example, the electrode bond portions 7 each have an approximately circular shape in the plan view, and a diameter of, for example, 5 µm or more and, for example, 500 µm or less. The distance between the electrode bond portions 7 is not especially limited.

### <Board Bondable Portion 8>

The wired circuit board 18 has not been bonded to the board bondable portion 8 via the molten metal 19 yet. The board bondable portion 8 can be recognized as a part on which a plating layer 9 described below is formed. The board bondable portion 8 is disposed at the other-side portion in the first direction of the metal plate 3. In other words, the board bondable portion 8 and electrode bond portions 7 are lined with a space therebetween in the first direction. Thus, the direction in which the board bondable portion 8 and electrode bond portions 7 are lined corresponds to the first direction. The board bondable portion 8 has an approximately sector shape in the plan view.

The outer peripheral edge of the board bondable portion 8 has a bond arc portion 80, a first bond straight line portion 81, and a second bond straight line portion 82. The bond arc portion 80 corresponds to the other-side portion in the first direction of the arc portion 13 in the plan view. The first bond straight line portion 81 corresponds to the other-side portion in the first direction of the chord portion 14 in the plan view. The second bond straight line portion 82 goes along an orthogonal direction orthogonal to the first direction and thickness direction (hereinafter, referred to as the orthogonal direction). The other edge in the first direction of the bond arc portion 80 is connected to the other edge in the first direction of the first bond straight line portion 81. The second bond straight line portion 82 connects one edge in the first direction of the bond arc portion 80 and one edge in the first direction of the first bond straight line portion 81. The plating layer 9 is provided on a one-side surface 11 of the board bondable portion 8.

### <Plating Layer 9>

The plating layer 9 is in contact with the whole of the one-side surface 11 of the board bondable portion 8. The plating layer 9 is a thin film or a thin layer. Examples of the material of the plating layer 9 include tin, and an alloy containing gold and nickel. The plating layer 9 has a thickness of, for example, 1 µm or more, preferably, 2 µm or more and, for example, 10 µm or less, preferably, 5 µm or less.

### <Opening 10>

The opening 10 is a penetrating hole penetrating the metal plate 3 in the thickness direction. The opening 10 is also a slit in the metal plate 3. The opening 10 is disposed between the electrode bond portions 7 and board bondable portion 8 in the first direction. Specifically, the opening 10 is disposed at an intermediate portion of the metal plate 3 in the first direction. The intermediate portion is between a one-side portion of the metal plate 3 and the other-side portion of the metal plate 3 in the first direction. The opening 10 extends in the orthogonal direction. Specifically, the opening 10 has an approximately endless inner edge 17 in the plan view.

The inner edge 17 has two semicircular opening portions 15 and two opening connection portions 16. The two semicircular opening portions 15 face each other with a space therebetween in the orthogonal direction. The semicircular opening portion 15 disposed at one side in the orthogonal direction has a central part protruding toward the one side in the orthogonal direction. The semicircular opening portion 15 disposed at the other side in the orthogonal direction has a central part protruding toward the other side in the orthogonal direction. The one side in the orthogonal direction is in a direction going away from the center of the battery 2. The other side is opposite to the one side. Each of the two opening connection portions 16 extends in the orthogonal direction. Each of the two opening connection portions 16 has a straight line shape in the plan view. One of the opening connection portions 16 connects one first-direction ends of the two semicircular opening portions 15 in the orthogonal direction. The other opening connection portion 16 connects the other first-direction ends of the two semicircular opening portions 15 in the orthogonal direction.

In the orthogonal direction, a ratio (L2/L1) of a length L2 of the opening 10 to a length L1 of a line segment passing through the opening 10 in the metal plate 3 is, for example, 0.3 or more, preferably, 0.5 or more and, for example, 0.95 or less. When the ratio (L2/L1) is the above-described lower limit or more, the heat transfer to the electrode bond portions 7 is efficiently suppressed when the wired circuit board 18 is bonded to the board bondable portion 8. When the ratio (L2/L1) is the above-described upper limit or less, the mechanical strength of the metal plate 3 is ensured. The length L2 of the opening 10 is a distance between the central parts of the two semicircular opening portions 15. The length L2 of the opening 10 is a maximum length of the opening 10 in the orthogonal direction. In FIG. 1, due to the limitations on the drawing, L1 and L2 are separately illustrated. However, L1 and L2 are in a straight line.

The first-direction length of the opening 10 is not especially limited. The first-direction length of the opening 10 is a distance between the two opening connection portions 16.

To produce the battery module 1, the battery 2 and metal plate 3 are prepared. To prepare the metal plate 3, the opening 10 is formed in the metal plate 3. The plating layer 9 is formed on the one-side surface 11 of the board bondable portion 8. Thereafter, the metal plate 3 is disposed on the electrode 5. The electrode bond portions 7 are formed by laser welding. The electrode bond portions 7 bond the metal plate 3 to the electrode 5.

Thereafter, as the phantom lines in FIG. 1 and FIG. 2 show, the wired circuit board 18 is bonded to the molten metal 19 through the board bondable portion 8. The molten metal 19 is, for example, a solder. The wired circuit board 18 has a flat belt shape extending in the first direction. The wired circuit board 18 has a terminal 20 disposed at the other side in the thickness direction.

To bond the wired circuit board 18 via the molten metal 19 to the board bondable portion 8, the molten metal 19 is disposed at the board bondable portion 8. Subsequently, the terminal 20 of the wired circuit board 18 is brought into contact with the molten metal 19. Thereafter, a heated chip 25 shown by the phantom line is pressed to a part corresponding to the terminal 20 on the one-side surface in the thickness direction of the wired circuit board 18. In this manner, the terminal 20 and molten metal 19 are heated. The molten metal 19 is molten by the heating, thereby bonding the wired circuit board 18 to the metal plate 3.

In this manner, the battery module with the wired circuit board 4 is produced. The battery module with the wired circuit board 4 includes the battery module 1, wired circuit board 18, and molten metal 19.

### <Use of Battery Module with Wired Circuit Board 4>

The battery module with the wired circuit board 4 is used for, for example, wireless power transmission devices and wearable devices. Examples of the wireless power transmission device include a small device. Specifically, examples of the small device include a hearing aid.

### <Operations and Effects of Embodiment

In the battery module 1, the metal plate 3 is disposed at the one side in the thickness direction relative to the electrode 5. Thus, the metal plate 3 is compactly disposed in the surface direction.

When the board bondable portion 8 is bonded to the wired circuit board 18 via the molten metal 19 and the heat of the molten metal transfers to the board bondable portion 8, the opening 10 disposed between the electrode bond portions 7 and board bondable portion 8 of the metal plate 3 can suppress an adverse heat transfer to the electrode bond portions 7. Thus, the deterioration of the properties of the battery 2 can be suppressed.

When the ratio (L2/L1) of the length L2 of the opening 10 to the length L1 of the line segment passing through the opening 10 in the metal plate 3 is 0.3 or more, the heat transfer to the electrode bond portions 7 can efficiently be suppressed when the wired circuit board 18 is bonded to the board bondable portion 8.

The battery module with the wired circuit board 4 includes the above-described battery module 1. Thus, when the board bondable portion 8 is bonded to the wired circuit board 18 via the molten metal 19 and the heat of the molten metal 19 transfers to the board bondable portion 8, the opening 10 suppresses the adverse heat transfer to the electrode bond portions 7. Thus, in the battery module with the wired circuit board 4, the deterioration of the properties of the battery is suppressed.

### <Variation>

In the following variation, the same members and steps as in the above-described embodiment are given the same numerical references and the detailed descriptions thereof are omitted. Further, the variation has the same operations and effects as those of the embodiment unless especially described otherwise. Furthermore, the embodiment and variation can appropriately be combined.

Although not illustrated, in the variation, a battery module 1 does not include a plating layer 9. Preferably, in the same manner as the Embodiment, the battery module 1 includes the plating layer 9. In the embodiment, the molten metal 19 easily wets and spreads over the plating layer 9 when the board bondable portion 8 is bonded to the wired circuit board 18 via the molten metal 19.

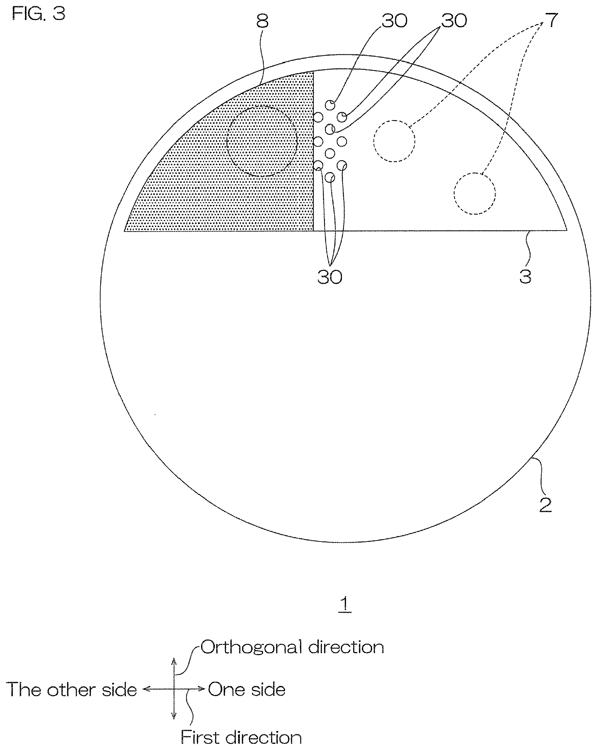

The shape of the opening 10 is not especially limited. The opening 10 can have, for example, an approximately rectangular shape in the plan view. As illustrated in FIG. 3, the opening 10 can be a plurality of circular holes 30. Each of the circular holes 30 penetrates the metal plate 3 in the thickness direction. The circular holes 30 are staggered in the plan view.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Description of Reference Numerals

- 1: battery module
- 2: battery
- 3: metal plate
- 4: battery module with the wired circuit board
- 5: electrode
- 6: one-side surface (one-side surface in the thickness direction of the battery)
- 7: electrode bond portion
- 8: board bondable portion
- 9: plating layer
- 10: opening
- 18: wired circuit board
- 19: molten metal
- 20: terminal
- 30: circular holes

## Claims

1. A battery module comprising:
a battery having a flat shape and including an electrode disposed on a one-side surface in a thickness direction of the battery; and
a metal plate disposed at one side in the thickness direction relative the electrode, the metal plate having an electrode bond portion bonded to the electrode,
wherein the metal plate includes:
a board bondable portion bondable to a wired circuit board via a molten metal; and
an opening disposed between the electrode bond portion and the board bondable portion, and penetrating the metal plate in the thickness direction.

2. The battery module according to Claim 1, further including a plating layer disposed on a one-side surface in the thickness direction of the board bondable portion.

3. The battery module according to Claim 1 or 2, wherein a ratio (L2/L1) of a length L2 of the opening to a length L1 of a line segment passing through the opening in the metal plate is 0.3 or more in a direction orthogonal to a direction in which the electrode bond portion and board bondable portion are lined.

4. A battery module with a wired circuit board comprising: a wired circuit board; a molten metal; and the battery module according to any one of Claims 1 to 3, wherein the wired circuit board is bonded to the board bondable portion via the molten metal.
